## Europäisches Patentamt

## European Patent Office

## Office européen des brevets

(19)

(11) Publication number: **0 057 073**

**B1**

(12)

# EUROPEAN PATENT SPECIFICATION

(45) Date of publication of patent specification: **25.09.85**

(21) Application number: **82300234.0**

(22) Date of filing: **18.01.82**

(51) Int. Cl.⁴: **G 01 S 1/30,** G 01 S 1/02, H 03 L 7/22

(54) **A hyperbolic navigation receiver.**

(30) Priority: **17.01.81 JP 5667/81**

(43) Date of publication of application:
**04.08.82 Bulletin 82/31**

(45) Publication of the grant of the patent:
**25.09.85 Bulletin 85/39**

(84) Designated Contracting States:
**DE FR GB NL SE**

(56) References cited:
**US-A-3 117 319**
**US-A-3 725 932**
**US-A-3 983 559**

**PATENT ABSTRACTS OF JAPAN, vol. 4, no.
168, (P-37) (650), November 20, 1980
PATENT ABSTRACTS OF JAPAN, vol. 4, no. 118
(P-24) (600), page 121P24, August 22, 1980
PATENTS ABSTRACTS OF JAPAN, vol. 3, no.
25, (E-94), page 145E94, February 28, 1979
PATENTS ABSTRACTS OF JAPAN; VOL: 5,
NO: 146, (P80) (818), September 16, 1981.
PATENTS ABSTRACTS OF JAPAN, vol. 5, no.
138, (P-78) (810), September 2, 1981**

(73) Proprietor: **FUJITSU LIMITED
1015, Kamikodanaka Nakahara-ku
Kawasaki-shi Kanagawa 211 (JP)**

(72) Inventor: **Tsukada, Kazuo
1-9, Saijyo Yamate 2-chome
Kakogawa-shi Hyogo, 675 (JP)**
Inventor: **Kanzaki, Yoshiharu
14-31, Onodai 7-chome Sagamihara-shi
Kanagawa, 229 (JP)**
Inventor: **Hori, Yoshikazu
2000-12-3-814, Kosugaya-cho Totsuka-ku
Yokohama-shi Kanagawa. 247 (JP)**

(74) Representative: **Sunderland, James Harry et al
HASELTINE LAKE & CO Hazlitt House 28
Southampton Buildings Chancery Lane
London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a receiver, for use in a hyperbolic navigation system.

In a hyperbolic navigation system a ship location is obtained from phase differences between low frequency signals emitted from master and slave stations.

A hyperbolic navigation system utilising a phase-discrimination method will be explained hereunder.

In such a navigation system, a chain comprising one master station and a plurality of corresponding slave stations (for example, a red station, a green station, and a purple station; a total of three slave stations) is ordinarily provided, and the slave stations are arranged in the form of a star around the master station. Each of the master and slave stations transmits a continuous multifrequency signal, each signal of a frequency which is a different multiple of a basic frequency of about 14 kHz. For example, where the basic frequency is 1f the master station transmits at 6f and the slave stations transmit at 5f, 8f and 9f respectively.

A receiver multiplies the signals transmitted from the master station and each slave station up to a frequency (a comparison frequency) which is the least common multiple of the master station signal frequency and the signal frequency of the slave station, to make equal the signal frequencies to be discriminated, and discriminates the phases of the signals transmitted from the master station and the slave station. Thus, three comparison frequencies, 30f, 24f and 18f, are employed.

The result of phase discrimination between the master station and each slave station indicates a hyperbola, pertaining to the particular slave station, upon which the ship is located. From the points of intersection of the three hyperbolas pertaining to the three slave stations the location of the ship can be determined.

Thus, in an existing receiver, as explained above, a phase-discrimination system is used in which a received signal is multiplied up to a least common multiple frequency and thereafter an incoming signal is phase-discriminated.

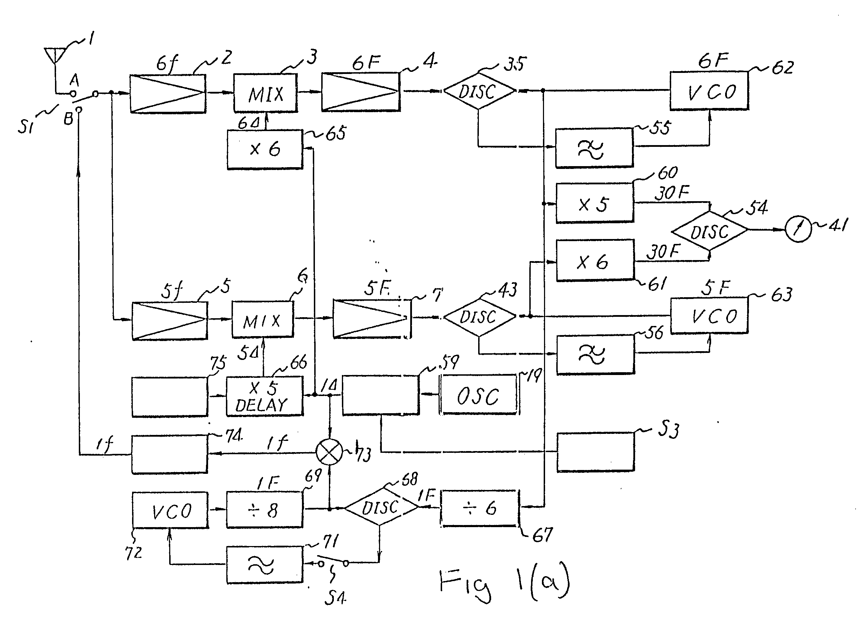

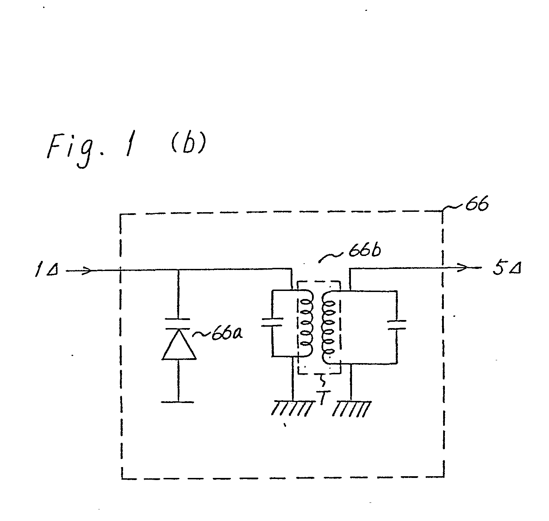

Figure 1(a) is a schematic block diagram of another previously proposed receiver, in which intermediate frequency signals are employed. Phase discrimination as effected in this receiver will be explained with reference to Figure 1(a).

Figure 1(a) shows only receiver components relating to phase discrimination of received signals of 6f (master station) and 5f (red station), but ordinarily phase discrimination of received frequencies of 6f (master station) and 8f (green station) and 6f (master station) and 9f (purple station) will be carried out using similar phase discrimination system components.

A received incoming signal from an antenna 1 is applied to high frequency amplifiers 2 and 5. These amplifiers respectively amplify the 6f signal from the master station and the 5f signal from a slave station selectively and then apply the amplified signals to mixers 3 and 6.

A local oscillator 19 generates, for example, a signal frequency $M\Delta$. This signal $M\Delta$ is applied to a frequency combiner 59 and therein divided in frequency by $1/M$ and pulse-formed. Thereafter, the signal is mixed with a signal sent from a chain selector $S_3$ and converted into a pulse signal of frequency $1\Delta$. Multipliers 65 and 66 respectively multiply the pulse signal $1\Delta$ in frequency by six and by five. The thus generated signals of frequencies $6\Delta$ and $5\Delta$ are applied to the mixers 3 and 6. The mixers 3 and 6 generate intermediate frequency signals of frequencies $6F(=6\Delta-6f)$ and $5F(=5\Delta-5f)$ respectively which are difference frequencies, and apply those signals to intermediate frequency amplifiers 4 and 7. Here, F is a basic intermediate frequency satisfying the relationship $F=\Delta-f$. The intermediate frequency amplifiers 4 and 7 respectively amplify the intermediate frequency signals 6F and 5F and apply those signals to phase-discriminators 35 and 43. The phase-discriminators 35 and 43 respectively phase-discriminate the intermediate frequency signals 6F and 5F with respect to an output signal, of frequency 6F, of a voltage controlled oscillator 62 and an output signal, of frequency 5F, of a voltage controlled oscillator 63, and then generate output signals corresponding to respective discriminated phase differences. The phase difference output signals of the phase discriminators 35 and 43 are smoothed by low pass filters 55 and 56, respectively, and fed back to the voltage control oscillators 62 and 63 respectively. Thereby the oscillation frequencies of the voltage controlled oscillators are controlled so that the respective phase difference output signals of the discriminators 35 and 43 approach zero.

As explained above, the outputs 6F and 5F of the voltage controlled oscillators 62 and 63 are phase-locked to the intermediate frequency signals 6F and 5F. The phase discriminator 35, voltage controlled oscillator 62 and low pass filter 55 operate as a narrow band tracking loop filter, and the phase discriminator 43, voltage controlled oscillator 63 and low pass filter 56 also operate as a narrow band tracking loop filter.

The output signals 6F and 5F of the voltage controlled oscillators 62 and 63 and are respectively multiplied in frequency by five and by six by multipliers 60 and 61 and thereby signals of frequency 30F are obtained. The 30F output signals from the multipliers 60 and 61 are phase-discriminated by a phase-discriminator 54, to provide an output corresponding to a phase difference which is displayed on a decometer 41.

As explained above, the method of phase discrimination used in the previously proposed receiver of Figure 1(a) involves the effecting of phase discrimination after multiplication of signal frequencies. Therefore, in the previously-proposed phase discrimination system, multiplier circuits are necessary for each receiving channel corresponding to each master or slave station frequency.

Figure 1(b) schematically illustrates the structure of a multiplier/phase shifter circuit 66. In Figure 1(b), 66a is a vari-cap, and T is a transformer which electrically couples two tuned circuits 66b. Here, the phase of an input pulse signal 1Δ is shifted by controlling the bias voltage of vari-cap 66a and a desired signal of a frequency which is a desired multiple of that of the input pulse signal is extracted from the harmonics of this pulse signal via the tuned circuit 66b.

The previously proposed receiver uses a multiplier as shown in Figure 1(b) and has the following disadvantages.

(1) Phase drift accompanying temperature change, and ageing fluctuation, occur relatively easily. That is, a phase drift inevitably occurs due to fluctuation of tuning frequency as a result of temperature change and due to ageing fluctuation of the tuned circuit 66b shown in Figure 1(b) (which is usually in the form of an LC filter).

(2) The receiver is expensive and is difficult to reduce in size. The tuned circuit for extracting multifrequency signals requires accurate phase adjustment and it is therefore usual to obtain desired characteristics by adjusting output amplitude and phase using a variable tuning type filter. Therefore, it is difficult to provide an adjustment-free operation and the system itself is expensive. The tuned circuit has different dimensions in dependence upon the frequency used; the receiver employs low frequency signals and as a result it is very difficult to realise a reduction in size.

Now, the need for the provision of a phase reference, and the reference method used in a previously proposed hyperbolic navigation receiver, will be explained.

In a hyperbolic navigation system, ship (receiver) location is determined from phase differences between signals from master and slave stations. Therefore, when the receiver is spaced respectively from the master station and a slave station by a distance which is integer multiples of the wavelengths of signals transmitted from those stations, and it receives multifrequency signals from both those stations which are of the same phase, the receiver must be so adjusted that a decometer of the receiver shows a zero phase difference. As a result, receiver phase referencing is actually carried out before a phase difference measurement is made. In practice a phase reference signal consisting of sharp pulses of a frequency 1f, which makes equal the phases of all multi-signals, is applied to the receiving input terminal. The oscillation signal phase of each receiving channel, corresponding to each station, is adjusted so that the harmonic signals 5f, 6f, 8f, and 9f selectively amplified from the 1f input signal produce, at each decometer, a zero phase difference indication.

In Figure 1(a), $S_1$ is a switch for selecting between "OPERATION" and "REFERENCE" modes of the receiver. When the switch $S_1$ is set to position A and the receiver is connected to the antenna, the receiver is ready for "OPERATION", whilst when the switch $S_1$ is set to position B and connected to a pulse generator, the receiver is ready for "REFERENCE". The switch $S_4$ is also employed to make the system ready for "OPERATION" by connecting phase-locked loop consisting of a phase-discriminator 68 a VCO 72, a divider 69 and a low pass filter 71, or ready for "REFERENCE" by disconnecting the phase-locked loop.

As explained above, when signals of frequencies 6f and 5f to be input to respective receiving channels corresponding to master and slave stations are of the same phase, the 30F outputs, which are respectively obtained by frequency-multiplying by five and by six the intermediate frequency outputs 6F and 5F of the receiving channels, must also be of the same phase.

In reality, however, differences in phase-shifts effective within the receiving channels corresponding to the master and slave stations means that the 30F outputs are not always of the same phase in these circumstances. Thus, the phase of the 5F intermediate frequency signal is calibrated by adjusting the phase of pulse signal 5Δ through control of multiplier/shifter 66 by ZERO adjusting means 75. Thereby, the phase of output 30F of the multiplier 61 is phase-locked to the 30F signal of the receiving channel corresponding to the master station.

In a hyperbolic navigation system the master and slave stations may each send a 1F signal and rough position setting may be carried out on the basis of these signals. This rough position setting, so-called "LANE IDENTIFICATION", is usually performed on the basis of the output of stages of the receiver preceding the discriminators 35, 43, and control of the phase of said intermediate frequency signal 5F as explained above is useful for facilitating this rough position setting.

The phase reference signal generator circuit of the receiver of Figure 1(a) will now be explained. In Figure 1(a), 72 is a voltage control oscillator which generates a frequency 8F; 69 is a 1/8 frequency divider; 68 is a phase discriminator; 71 is a low-pass-filter; 67 is a 1/6 frequency divider; 73 is a mixer; and 74 is a pulse shaper.

When the select switches $S_1$ and $S_4$ are set to their "OPERATION" positions the voltage controlled oscillator 72 is oscillating at a frequency 8F which is phase-locked to the output signal 6F of the voltage controlled oscillator 62 via the phase discriminator 68. This 8F signal does not have any effect upon the receiving channels corresponding to the master and slave stations when the receiver is in the "OPERATION" mode.

When the receiver is switched to the "REFERENCE" mode, from the "OPERATION" mode, the phase discrimination output of the phase discriminator 68 is disconnected from the oscillator 72 and thereby the oscillator 72 operates as a local oscillator which oscillates with a frequency and phase as set just before switching to "REFERENCE" mode. The output 8F of this voltage controlled oscillator 72 is divided to 1F by the frequency divider 69 and then mixed with the local oscillation frequency $1\Delta$, sent from the frequency combiner 59, at the mixer 73, providing a signal 1f which is exactly the same as the basic frequency 1f of the receiving signals and then converted to narrow reference pulses of frequency 1f by means of the pulse shaper 74. These narrow pulses are rich in harmonics.

Since the harmonics 5f, 6f, 8f, 9f of the reference pulses are respectively of the same amplitude and same phase, the zero-phase referencing of the receiver can be effected by applying these harmonics to the receiving channels corresponding to master and slave stations, via the select switch $S_1$, by setting the ZERO adjust means 75 so that the decometer 41 (for example) indicates zero-phase.

However, this method of phase referencing as employed in the previously proposed receiver has the following disadvantages.

(1) Voltage controlled oscillator 72 for reference and the phase discrminator 68 for phase-locking the oscillator 72 are required in addition to other components of the receiver.

(2) Since the oscillator 72 runs freely when oscillating as a local oscillator during "REFERENCE" mode, any drift of frequency and phase during calibration appears as an error in the reference pulse signal and as a result calibration is carried out with a signal having a frequency different from the 1f receiving signal frequency and therefore phase calibration becomes inaccurate. In order to prevent this occurring, an expensive but stable voltage controlled type crystal controlled oscillator has previously been used for the voltage controlled oscillator 72.

(3) To synchronise the voltage controlled oscillator 72 to the voltage controlled oscillator 62 with excellent stability over a wide ambient temperature range it is necessary to precisely control the temperature coefficients of the respective crystal oscillation units, involving further expense. However, in practice, operation of an oscillator can easily become unstable due to a difference of temperature coefficient.

In the previously proposed receiver phase shift is effected using a variable capacitance, such as the vari-cap of Figure 1(b), for calibration. This variable capacitance is expensive because it must have excellent linearity. Moreover, the temperature coefficient of the variable capacitance etc. is generally large so that phase drift of the reference circuit itself cannot be ignored.

As explained previously the previously proposed receiver requires multipliers and expensive oscillators for phase reference and phase discrimination which makes it difficult to provide a reduction in size and a relatively inexpensive receiver.

US—A—3 117 119 discloses a navigational system having a receiver for four transmitted frequencies, a detector providing first order heterodyne signals and phase comparison means. Frequency dividers are employed for dividing a local signal of a basic heterodyne frequency, for providing frequency divided signals for comparison with the first order heterodyne signals.

JP—A—55 74475 discloses a hyperbolic navigation receiver very similar to that of Fig. 1(b) and also discloses such a receiver using voltage controlled phase shifters and frequency dividers instead of some of the multipliers and voltage controlled oscillators on the filter side of the receiver.

JP—A—55 113 971 discloses a hyperbolic navigation receiver ccording to the precharacterising part of claim 1.

According to the present invention there is provided a hyperbolic navigation receiver, having

first and second receiving channels, being a master channel and a slave channel respectively, corresponding respectively to a master station and a slave station of a hyperbolic navigation system, each said receiving channel comprising receiving means for receiving and distinguishing a receiving signal pertinent to the channel concerned and the said receiving channels being operable respectively to provide first and second channel output signals in dependence upon such pertinent receiving signals,

first and second tracking loop filters operable respectively to provide first and second tracking output signals of frequencies equal respectively to those of the first and second channel output signals,

first and second phase discriminating means operable respectively to phase discriminate the first channel output signal and the first tracking output signal and to phase discriminate the second channel output signal and the second tracking output signal, and

further phase discrimination means operable to phase discriminate signals derived from the first and second tracking loop filters,

the first and second tracking loop filters each comprising first generating means operable to provide a generator output signal of a frequency a multiple of that of the receiving channel output signal with which the tracking output signal of the filter is phased indiscriminated, and first frequency dividing means for dividing the frequency of the generator output signal to that of the receiving channel output signal with which the tracking output signal of the filter is phase-discriminated, the first generating means of the first tracking loop filter comprising a first voltage controlled oscillator and the first generating means of the second tracking loop filter comprising a voltage controlled phase shifter arranged to receive a signal derived from the first tracking loop filter,

the receiver further comprising second generating means (19 to 26) operable to generate a local signal,

and each receiving means comprising input means for a receiving signal pertinent to the channel concerned, and

first mixing means for mixing a signal from the input means with a mixing signal of a frequency dependent upon that of the receiving signal pertinent to the channel concerned, derived from the local signal, to provide an intermediate frequency signal as the receiving channel output signal of the channel concerned, characterised in that

each receiving means has second frequency dividing means for dividing the frequency of the local signal to provide the mixing signal for the first mixing means of the receiving means concerned.

In a receiver embodying the present invention the same frequency can be used (for frequency generation in each channel) without the employment of multipliers for providing outputs corresponding to respective receiving channels corresponding to master and slave stations for performing phase discrimination.

In a receiver embodying the present invention signals at a multiple of a basic frequency $1\Delta$ can be generated without using multipliers and these signals used to effect modulation when a received signal is modulated to an intermediate frequency.

In a receiver embodying the present invention a phase discrimination system can be employed which does not require respective voltage controlled oscillators for referencing and for phase discrimination.

In a receiver embodying the present invention a method of referencing can be employed in which phase drift in the reference circuit itself is of no effect, without the need to use a variable capacitance element as shown in Figure 1(b).

A receiver embodying the present invention employs a phase-discrimination system which does not require multipliers and a method of phase referencing which does not require an oscillator exclusively for referencing use.

In an embodiment of the present invention, frequency multiplication for the purposes of phase discrimination is not required; use is made of an oscillator which generates a signal of a frequency which is a multiple of a receiving signal frequency, or of the frequency of a signal obtained by modulating a receiving signal into an intermediate frequency. Moreover, when synchronisation is effected between a signal obtained by modulating a receiving signal into an intermediate frequency signal and an oscillator output, the oscillator output is frequency divided, and the phases of the frequency divided oscillator output and intermediate frequency signals are discriminated, thereby to form a tracking loop filter. A multiplier previously required for providing signals of the same frequency for phase discrimination is no longer required.

Further, in an embodiment of the present invention it is not necessary to provide respective voltage controlled oscillators for receiving channels corresponding to the master and slave stations. For example, a voltage controlled oscillator which generates a signal of a frequency which is a multiple of receiving signal frequency, or a multiple of the frequency of a signal obtained by modulating the receiving signal into an intermediate frequency, is provided only in respect of a receiving channel corresponding to the master station, whilst voltage controlled phase shifters, which control the phase of the output of the voltage controlled oscillator in accordance with a phase difference from a receiving signal, or from a signal obtained by modulating the receiving signal into the intermediate frequency, are provided in respect of the other receiving channels. As compared with a voltage controlled oscillator, a voltage controlled phase shifter is more economical and smaller in size, therefore providing for a reduction in size and cost of the receiver as a whole.

In a receiver embodying the present invention a loop forming the tracking loop filter (for example including the voltage controlled oscillator) provided in respect of a receiving channel can be disconnected from the receiving channel and its output alternatively used for generation of 1f pulses for referencing, as a local oscillator output. Namely, there is provided a method of phase discrimination in which a voltage controlled phase shifter is provided for establishing a phase relationship, just before "REFERENCE" mode is selected, between the oscillator output and a receiving signal, or a signal obtained by modulating such a receiving signal into an intermediate frequency, and thereby the use of separate voltage controlled oscillators for reference and phase discrimination can be avoided.

In a receiver embodying the present invention a $M\Delta$ ($\Delta$: basic frequency, M: integer) signal used for modulation of a receiving signal into an intermediate frequency (by mixing in a receiving channel) is generated by dividing a signal of a frequency a multiple that of the $M\Delta$ signal. Thereby, a zero-adjust system in which there is no phase drift in the referencing circuit itself can be provided, in which a multiplier which has previously been used for multiplying a $1\Delta$ signal to provide the specified $M\Delta$ signal is no longer required, and in which a high frequency transformer, a tuning circuit and a variable capacitance element as shown in Figure 1(b) are not required.

In a receiver embodying the present invention frequency division using small size and economical circuits having no drift, for example counters, can be successfully realised to obtain the $M\Delta$ output, and digital signals for the counters can be controlled from a microprocessor for zero adjustment in the "REFERENCE" mode.

Reference is made, by way of example, to the accompanying drawings, in which:—

Figure 1(a) is a schematic block diagram of a previously proposed receiver as discussed above

Figure 1(b) schematically illustrates the structure of a multiplier used in the receiver of Figure 1(a),

Figure 2 is a schematic block diagram of a receiver embodying the present invention,

Figure 3 is a block diagram for assistance in explanation of phase discrimination between receiving channels corresponding to master and slave stations in a receiver embodying the present invention,

Figure 4 is a schematic block diagram illustrating the general structure of a frequency divider used in a receiver embodying the present invention,

Figure 5 is a block diagram for assistance in explanation of phase discrimination in a receiver embodying the present invention, and

Figure 6 is a schematic circuit diagram illustrating the general structure of a voltage controlled phase shifter used in a receiver embodying the present invention.

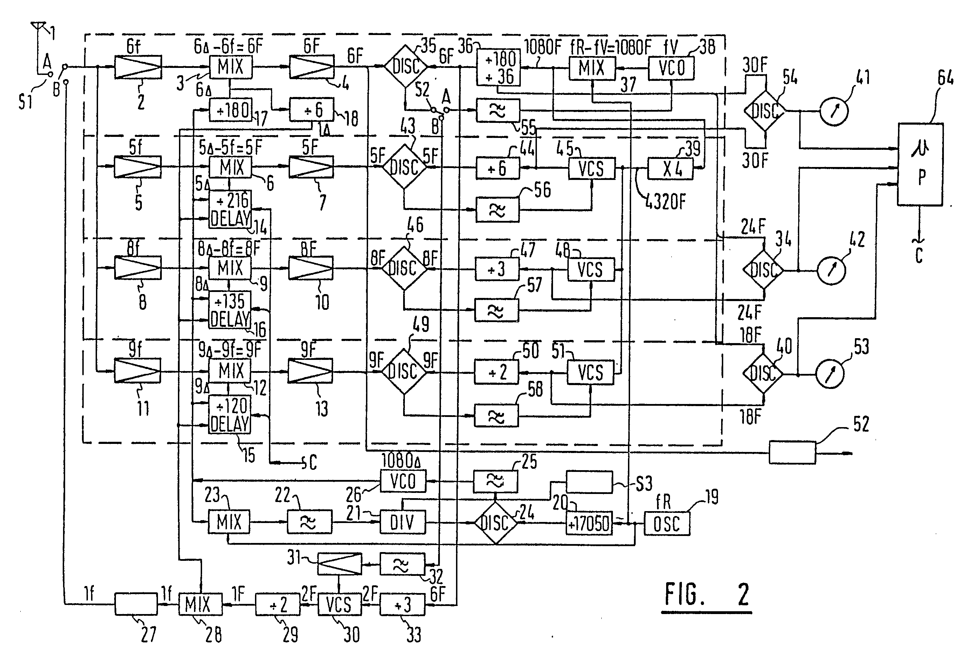

The receiver of Fig. 2 can be designed to be of small size, that is, one half or less the size of a previously proposed receiver, so that it can be used more easily for small size vessels, and moreover can be designed to be of an automatic type which eliminates the need for precise adjustment and complicated operations, so that even a beginner can operate the receiver easily.

In Figure 2, 1 is a receiving antenna; $S_1$ is a select switch for changing over between the receiving antenna 1 and reference pulses 1f; 2, 5, 8 and 11 are high frequency amplifiers which selectively and respectively amplify a signal (6f) of a master station, a signal (5f) of a first slave station, a signal (8f) of a second slave station, and a signal (9f) of a third slave station; 3, 6, 9 and 12 are mixers which mix the signals sent from the high frequency amplifiers and specified $M\Delta$ signals (6$\Delta$, 5$\Delta$, 8$\Delta$, 9$\Delta$ respectively for the mixers 3, 6, 9, 12) and generate respective intermediate frequencies (6F, 5F, 8F, 9F) and 4, 7, 10 and 13 are narrow band intermediate frequency amplifiers the centre frequencies of which are equal to the respective intermediate frequencies generated by the mixers with which they are respectively connected.

19 is a local oscillator which generates a reference frequency local oscillation signal; 20 is a fixed frequency divider which provides a division factor of 1/17050; 24 is a phase discriminator which outputs an error voltage according to a discriminated phase difference; 22 and 25 are low pass filters; 26 is a voltage controlled oscillator which generates a frequency (1080$\Delta$) in accordance with the error voltage from 24; 23 is a mixer; 21 is a variable frequency divider the frequency division ratio of which is changed in dependence upon a control signal sent from a chain selector switch $S_3$. 14 is a frequency divider with a division factor of 1/216 which generates the signal 5$\Delta$ from the signal 1080$\Delta$, and a delay line; 15 is a frequency divider with a division factor of 1/120 which generates 9$\Delta$ from 1080$\Delta$, and a delay line; 16 is a frequency divider with a division factor of 1/135 which generates 8$\Delta$ from 1080$\Delta$, and a delay line; 17 is a frequency divider with a division factor of 1/180 which generates 6$\Delta$ from 1080$\Delta$; and a 18 is a frequency divider with a division factor of 1/6.

$S_2$ is a switch for selecting "OPERATION" and "REFERENCE" modes. 31 is a DC amplifier; 32 is a low pass filter; 33 is a frequency divider with a division factor of 1/3; 30 is a voltage controlled phase shifter which is controlled by an error voltage from 31 and outputs a shifted signal of frequency 2F; 29 is a frequency divider with a division factor of 1/2; 28 is a mixer which generates a 1f signal from 1F and 1$\Delta$ signals 27 is a 1f pulse-former which generates narrow pulses of frequency 1f.

35, 43, 46 and 49 are 6F, 5F, 8F and 9F phase discriminators which discriminate between respective intermediate frequency outputs and respective tracking loop filter outputs; 36, 44, 47 and 50 are frequency dividers with division factors as indicated in Figure 2; 37 is a mixer which mixes the output of local oscillator 19 and the output of a voltage controlled oscillator 38.

Frequency drift of the local oscillator 19 is substantially cancelled between the pairs of inputs of the phase discriminators 35, 43, 46 and 49. That is, frequency drifts of local oscillator 19 are mixed in the mixer 37 and thereby are present in the generation of the specified intermediate frequency signals by dividers 36, 44, 47 and 50. Further, the frequency drifts are manifest in the 1080$\Delta$ signal (from VCO 26) via phase discriminator 24, low pass filter 25 and voltage controlled oscillator 26 and therefore the frequency drifts of local oscillator 19 are included in each $M\Delta$ signal to be input to the mixers 3, 6, 9 and 12. As a result, any frequency drift of local oscillator 19 is manifest in the modulated intermediate frequency signal from each receiving channel. Moreover, as explained above, the frequency drifts are also included in the intermediate frequency signals which are outputs of the frequency dividers 36, 44, 47 and 50, and the frequency drifts included in the pairs of signals discriminated by the phase discriminators 35, 43, 46 and 49 mutually cancel.

Namely, frequency drifts of local oscillator 19 can be cancelled by inputting the output signal of mixer 37 to voltage controlled phase shifters 45, 48 and 51 provided in respective tracking loop filters corresponding to the receiving channels corresponding to respective slave stations, as explained below, and by using the output signal of mixer 37 as an oscillation output source in respect of all receiving channels.

In the embodiment of Figure 2 this is achieved through the provision of 4-times multiplier 39, 1/144±1 variable divider/phase shifter 45, 1/180±1 variable divider/phase shifter 48, 1/240±1 variable divider/phase shifter 51 in correspondence to respective receiving channels. The output 1080F of the mixer 37 is divided (illustrated only schematically) to provide specified 30F, 24F and 18F signals which are output with the same phase as incoming signals from respective receiving channels.

In Figure 2, 52 is a multi-phase detector circuit which obtains a 1F output from a multi-pulse signal combining the intermediate frequency outputs 6F, 5F, 8F and 9F of amplifiers 4, 7, 10 and 13. The output of this circuit 52 is used for so-called Lane Identification in a hyperbolic navigation system employing a method of phase discrimination. As mentioned above, a hyperbolic navigation system can be provided in which the master and slave stations send particularly a 1f signal at a predetermined time and rough position setting may be carried out. So-called "LANE IDENTIFICATION" can be performed.

53, 34 and 40 are 30F, 24F and 18F phase discriminators. 64 is a microprocessor for control and signal processing. A control output C of this microprocessor is input to the frequency dividers 14, 15 and 16 thus to control zero-adjustment during referencing by means of a digital signal. 41, 42 and 53 are decometers of the receiver. 55 to 58 are low pass filters.

Phase discrimination in a receiver embodying the present invention will now be explained.

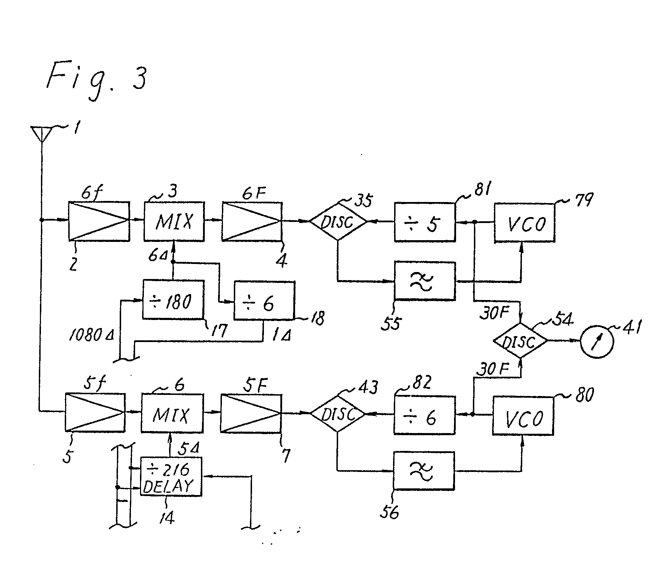

Figure 3 is a block diagram showing principal parts relating to phase discrimination in a receiver embodying the present invention. The arrangement in Figure 3 corresponds in general to that of Figure 2 but differs in certain respects.

In Figure 3, parts corresponding to those shown in Figure 2 are given the same reference numbers. In Figure 3, 79 and 80 are voltage controlled oscillators; and 81 and 82 are frequency divider circuits.

As explained above, in Figure 2, a voltage controlled oscillator is not provided in respect of the receiving channel corresponding to the 5f receiving signal, and in Figure 2 an output (delivered to the right hand side of discriminator 43) is generated by controlling the phase of an output derived from (mixer 37) of the tracking loop filter corresponding to the receiving channel corresponding to the master station. However, Figure 3 relates to an embodiment in which voltage controlled oscillators 79 and 80 which generate 30F outputs are provided and in which 1/5 frequency divider 81 and 1/6 frequency divider 82 are used, but in which there is no multiplier equivalent to multiplier 39 of Figure 2.

In the embodiment of Figure 3, the structure and operation from the receiving signal input point to the output points of intermediate frequency amplifiers 4 and 7 are the same as those of the embodiment of Figure 2.

The voltage control oscillators 79 and 80 generate signals of frequency 30F. These signals are applied respectively to the frequency dividers 81 and 82 and subjected thereby to division factors of 1/5 and 1/6, generating signals 6F and 5F.

The phase discriminator 35 in Figure 3 discriminates phase difference between the output 6F of the divider 81 and the output 6F of intermediate frequency amplifier 4, and then generates an output in accordance with the phase difference. This output is smoothed via low pass filter 55 and fed back to the voltage controlled oscillator 79 to control its oscillation frequency to cause the phase difference output to approach zero. Thereby, the output 30F of the voltage controlled oscillator 79 is phase-locked to the intermediate frequency signal 6F from amplifier 4. The voltage controlled oscillator 79, frequency divider 81 and low pass filter 55 form a narrow band tracking loop filter co-operating with phase discriminator 35.

In the same way, the voltage controlled oscillator 80, frequency divider 82 and low pass filter 56 form a narrow band tracking loop filter co-operating with phase discriminator 43. The voltage controlled oscillator 80 generates an output frequency 30F which is phase-locked to the output 5F of the intermediate frequency amplifier 7.

The phase discriminator 54 discriminates phase difference between the phases of the output 30F signal of voltage control oscillator 79 and the output 30F signal of voltage control oscillator 80 and generates an output in accordance with the phase difference, and the decometer 41 displays that output.

Here, the phase relationship between the output signals of oscillators 79 and 80 (before frequency division) and the output signals of frequency dividers 81 and 82 is determined by the conditions of the dividers 81 and 82 at the commencement of operations and will not be changed during operation. It may thus be thought that phase relationship between signals before and after frequency division might be different for each input of power source voltage (e.g. each time the receiver is switched on). However, changes in phase relationship from this cause fluctuate at the rate of $2\pi$ (rad) in terms of the phase of a signal before frequency division, or integer multiples of one cycle. Since phase differences between receiving signals in receiving channels corresponding to master and slave stations are set within the range of one cycle of the output signals of the voltage controlled oscillator 79 and 80, no adverse effects are caused and no measurement errors arise even if the phase of a signal from a voltage controlled oscillator 79 or 80 changes by a multiple of one cycle.

Since the oscillation frequency of each voltage controlled oscillator (79 and 80) which forms a tracking loop filter is set to a frequency which is an integer number of times the intermediate frequency (or an integer number of time received signal frequency), phase discrimination in relation to receiving channel signals corresponding to both master and slave stations can be realised without using multipliers.

Further explanation of operations will now be given with reference to the embodiment of the present invention shown in Figure 2.

In Figure 2, receiving inputs (6f from the master station and 5f from a slave station) of the receiving antenna 1 are respectively amplified by the high frequency amplifiers 2 and 5, and mixed with local oscillation signals $6\Delta$ and $5\Delta$ generated by the dividers 17 and 14 at the mixers 3 and 6, thus generating 6F and 5F intermediate frequency signals. These intermediate frequency signals are respectively amplified by the intermediate frequency amplifiers 4 and 7 and then applied to the phase discriminators 35 and 43 respectively.

Meanwhile, the mixer 37 mixes a signal $f_v$ from the voltage controlled oscillator 38, and a signal $f_R$ from the local oscillator 19, and generates a frequency difference signal of frequency 1080F. The signal 1080F is divided to 1/180 its original frequency by the frequency divider 36 and then applied to the phase-discriminator 35 as a signal 6F. The phase discriminator 35 thus receives two 6F signals and generates an output voltage in accordance with phase difference between them. This output voltage is fed back to the voltage controlled oscillator 38 via the low pass filter 55, for controlling the oscillation frequency of the oscillator 38. The voltage controlled oscillator 38, mixer 37, frequency divider 36, and low pass filter 55 form a narrow band tracking loop filter co-operating with phase discriminator 35, as in the case of Figure 3.

The output signal 1080F of mixer 37 is multiplied by four at the multiplier 39, generating a signal of frequency 4320F. The signal 4320F is applied to the voltage controlled phase shifter 45 and divided in accordance with a division factor $1/(144\pm1)$, generating an output signal of frequency 30F. The output signal 30F is divided to 1/6 its original frequency by the frequency divider 44, generating an output signal 5F which is applied to the phase discriminator 43.

The phase discriminator 43 thus receives two 5F signals and generates an output in accordance with phase difference between them. This output is fed back to the voltage control phase shifter 45 via the low pass filter 56, controlling the frequency division ratio thereof, and thereby controlling its output frequency. The voltage controlled phase shifter 45, frequency divider 44, and low pass filter 56, form a narrow band tracking loop filter co-operating with phase discriminator 43.

An output signal 30F of the frequency divider 36 (the 1080F input signal of 36 subjected to a 1/36 division factor) and the output signal 30F of the voltage control phase shifter 45 are discriminated by the phase discriminator 54, generating an output in accordance with the phase difference between them. The decometer 41 displays such outputs.

The voltage control oscillator 26 generates a local oscillation signal of frequency $1080\Delta$. This signal is mixed with the signal reference oscillator 19 at the mixer 23. Only a desired frequency band is selectively extracted by the band (low) pass filter 22 and then frequency division is effected by the variable frequency divider 21. The frequency division ratio of variable frequency divider 21 can be set externally by the chain selector $S_3$. On the other hand, the fixed frequency divider (1/17050) 20 divides the output signal $f_R$ of the reference local oscillator 19 in accordance with the fixed division ratio 1/17050. The output signals of the two frequency dividers 21 and 20 are discriminated by the phase discriminator 24, thus generating an output voltage in accordance with the phase difference between them. This output voltage controls the oscillation frequency of the voltage controlled oscillator 26 through a low pass filter 25 and phase locks the voltage controlled oscillator 26 to the frequency of local oscillator 19. The loop including the voltage control oscillator 26 forms a synthesizer circuit and generates a local oscillation signal at a constant frequency interval which corresponds to the chain (of stations) from which signals are currently being received.

The local oscillation signal $1080\Delta$ generated by the voltage controlled oscillator 26 is divided by the frequency divider 17 in accordance with a division factor 1/180, and divided in accordance with a division factor 1/216 by the frequency divider 14, respectively generating the signals $6\Delta$ and $5\Delta$ which are applied to the mixers 3 and 6 as explained previously.

Here, the output signal $f_v$ of the voltage controlled oscillator 38 corresponds in general terms to the output of the voltage controlled oscillator 79 of the embodiment of the present invention shown in Figure 3.

In a receiver embodying the present invention for use as a hyperbolic navigation receiver the intermediate frequency is usually set very low, for example in the range 5 to 10 kHz, so frequency drift of the local reference signal $f_R$ of the local oscillator 19 can become a particular problem. Therefore, in the embodiment of the present invention shown in Figure 2, the 30F output (to discriminator 54) and the 6F output (to discriminator 35) are obtained via the frequency divider 36 in accordance with the beat frequency effective between (the frequency difference between) the output signal $f_v$ of the voltage controlled oscillator 38 and the local reference signal $f_R$. On the other hand, the voltage controlled oscillator 26 outputs the $1080\Delta$ signal in sychronisation with the output of the local oscillator 19, whilst the mixer 3 generates the 6F signal (supplied to amplifer 4) from the beat frequency effective between the $6\Delta$ signal obtained by dividing the $1080\Delta$ signal in accordance with the division factor of 1/180 and the receiving signal 6f. Therefore, effects of frequency drift of the local reference signal $f_R$ are cancelled in the phase discriminator 35 as explained above.

As will be clear from the embodiments of the present invention shown in Figures 2 and 3, phase discrimination in a receiver embodying the present invention does not require multipliers (as will be seen particularly from Figure 3 although a multiplier may be employed as seen at 39 Figure 2), and frequency dividers only are required for detecting phase difference in relation to an intermediate frequency signal obtained by modulating a receiving signal. It will be seen from Figures 2 and 3 that no multipliers are employed for obtaining the intermediate frequency signals 6F, 5F etc., on the receiving side of discriminators 35 and 43 etc. As compared with the prior art receiver of Figure 1(a), the receivers of Figures 2 and 3 employ fewer or no multipliers, and fewer oscillators.

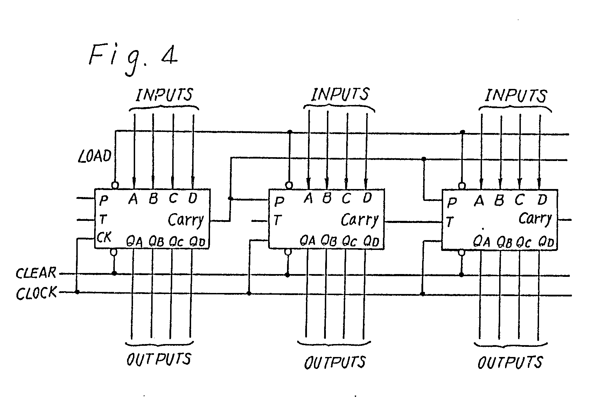

Figure 4 shows a frequency divider employed in a receiver embodying the present invention. The frequency divider shown in Figure 4 comprises programmable counters connected in a multistage arrangement which allows data to be input in advance to INPUTS of the counters, which counters count-down a data value in response to externally applied clock pulses (or count-up such a data value). The frequency division is provided in accordance with a specified frequency division ratio using the clock pulses from OUTPUTS terminals of the counters.

The frequency divider is of a well known structure allowing the employment of digital IC's and adjustment free operation, and is very economical, and its division ratio is not subject to change due to ageing fluctuation.

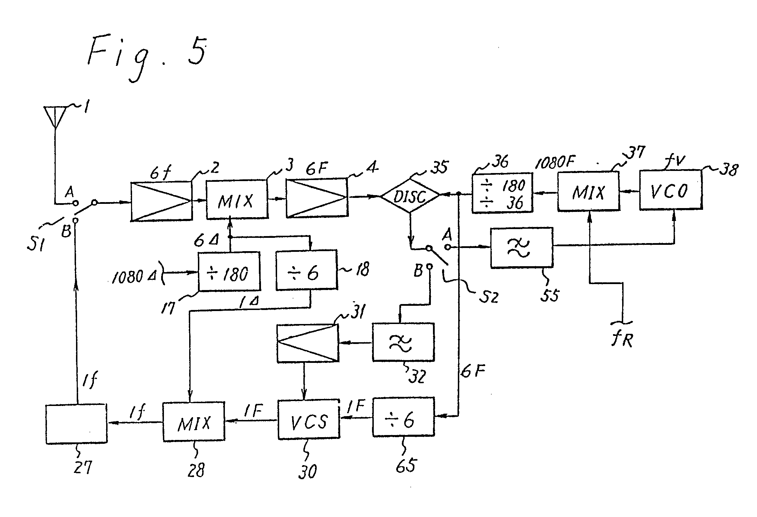

The reference pulse generating method employed in an embodiment of the present invention will now be explained. Figure 5 shows principal parts relating to phase reference pulse generation in a receiver similar to that of Figure 2. In Figure 5, parts similar to those shown in Figure 2 are given the same reference numbers. In Figure 5, 65 is a 1/6 frequency divider combining the functions of dividers 29 and 33 of Figure 2.

When the select switches $S_1$ and $S_2$ are set to the "OPERATION" side, side A in Figure 5, receiving channels corresponding to the master and slave stations selectively receive receiving signals 6f, 5f etc and phase differences are displayed as explained above.

The 6F signal obtained by division of the 1080F output of mixer 37 in the divider 36 is here considered to have a constant phase difference of 90° relative to the 6F signal obtained by modulating the receiving signal (6f) with the intermediate frequency signal 6Δ. When the select switches $S_1$ and $S_2$ are then set to the "REFERENCE" side, side B, the voltage controlled oscillator 38 continues oscillation, maintaining frequency and phase as set immediately before switching of the select switches.

Meanwhile, the voltage controlled phase shifter 30 receives the output of the phase discriminator 35 of the receiving channel corresponding to the master station, via low pass filter 32 and DC amplifier 31, and simultaneously the output of voltage controlled phase shifter 30 is applied again to the phase discriminator 35 via the mixer 28, pulse shaper 27, select switch $S_1$, high frequency amplifier 2, mixer 3 and intermediate amplifier 4. That is, the circuits mentioned above form a phase control loop. Therefore, phase shift in the voltage controlled phase shifter 30 is controlled by the output of phase discriminator 35, and finally the phase of the 1F output provided by means of the voltage controlled phase shifter 30 is controlled so that the output of phase discriminator 35 becomes zero; that is, so that phase difference between the divided output 6F of the frequency divider 36 and the intermediate frequency 6F derived from the input receiving signal (which is supplied from voltage control phase shifter 30 in the "REFERENCE" mode) becomes (is phase-locked at) 90°. The 1F output thus obtained is the same as the 1F output generated by the frequency divider 69 of Figure 1(a).

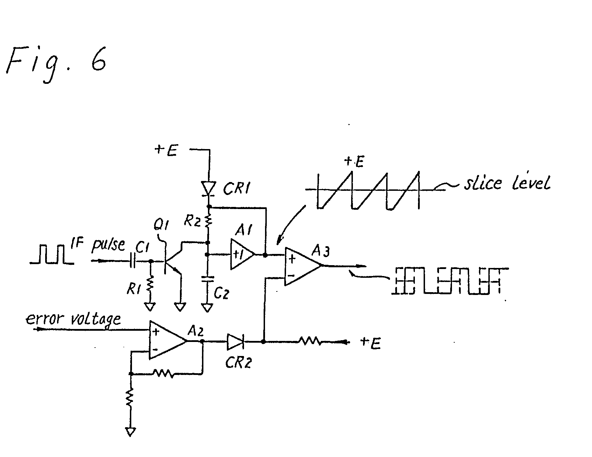

A monostable multivibrator can be used as the voltge controlled phase shifter 30 and it is alternatively possible to use in combination a sawtooth wave oscillator and a voltage comparator. Figure 6 illustrates an example of such a voltage controlled phase shifter.

In Figure 6, a sawtooth wave oscillator comprises a capacitor $C_2$, a resistor $R_2$, a transistor $Q_1$, a diode $CR_1$ and operational amplifiers $A_1$ (voltage gain+1) having a high input impedance, and $A_2$ etc. A capacitor $C_1$ and a resistor $R_1$ form a differential circuit (for differentiating square waves) in order that narrow drive pulses are applied to the transistor $Q_1$. The inclination of the sawtooth wave provided by the sawtooth wave oscillator is determined by the values of $C_2$ and $R_2$ and the linearity of that inclination is maintained by positive feed-back through the operational amplifier $A_1$ and by the diode $CR_1$ which prevents the reverse flow of current. $A_2$ is an operational amplifier for error amplification and its output is applied to one input terminal of voltage comparator $A_3$. The sawtooth wave output of the operational amplifier $A_1$ is applied to the other input of $A_3$, and the rising phase of an output signal of the voltage comparator $A_3$ can be controlled by slicing the sawtooth wave signal in accordance with the error voltage sent from the low pass filter 32 (Figure 2). A zener diode $CR_2$ is a DC level converter for slicing the sawtooth wave at a central position when an error voltage is 0V.

The voltage controlled phase shifter used for phase referencing need not employ special, expensive parts such as a crystal oscillation unit, and can be formed easily of more economical components. Moreover, the voltage controlled phase shifter outputs a signal which is the same as the input signal in frequency but is different in phase. This fact eliminates the problem of drift of reference signal frequency in the "REFERENCE" mode, which is often observed when a crystal controlled oscillator is used as in the previously proposed receiver.

Phase control for phase reference in an embodiment of the present invention will now be explained in more detail.

In Figure 2, the signal sent from the local oscillator 19 is applied to the frequency divider 20 and to mixer 23. An output of the frequency divider 20 is input to one input terminal of phase discriminator 24. The output signal 1080Δ of the voltage control oscillator 26 is applied to the mixer 23 and mixed with the signal from local oscillator 19 and the result applied to the low pass filter 22, thereafter divided in frequency as specified by the variable frequency divider 21 and then applied to the phase discriminator 24. The output of the phase discriminator 24 controls the 1080Δ signal of the voltage controlled oscillator 26 after unwanted elements are eliminated by the low pass filter 25. The output of oscillator 26 is then input to the frequency dividers 14 to 17 which output local signals 6Δ, 5Δ, 8Δ, and 9Δ. At this time, the frequency division phase of a divider is controlled by controlling the division ratio of the divider, which consists of counters. That is, if the frequency division ratio is taken to be N (i.e. if the division factor is taken to be 1/N) phase is controlled so that it is advanced or retarded in steps of 360°/N by changing the division ratio to N−1 or N+1. During phase referencing control pulses are applied to the frequency dividers 14 to 16 from the microprocessor 64. Thereby, the frequency dividers 14 to 16 are preset and division phase can be made uniform.

Control timing is synchronised by means of the 1Δ signal obtained by dividing the signal 6Δ in the frequency divider 18.

Moreover, for fine control of phase, a specified resolution can be obtained using the delay lines provided in respect of the frequency dividers 14 to 16. Generally, an LC passive circuit system is used for providing a delay line but it is alternatively possible to use gate circuits of the semiconductor IC type. In other words, it is possible to connect a plurality of gate circuits in series then to control phase delay by changing the number of circuits actively connected in series.

Characteristics of receivers embodying the present invention will now be listed below.

1. Adjustment-free operation can be realised because no multipliers need be used, and since variation resulting from frequency division is very small (usually changes (increases and decreases) of delay time due to temperature changes of frequency dividers composed of digital IC's are very small), a very stable phase discrimination system can be realised very economically.

2. The number of expensive voltage controlled oscillators required can be reduced drastically through the provision of phase locking to a receiving signal, or to an intermediate frequency signal obtained by modulating a receiving signal, by means of voltage controlled phase shifters provided in respect of receiving channels corresponding to slave stations and by using only one voltage controlled oscillator provided in respect of the receiving channel corresponding to the master station.

3. If a receiving signal is modulated to an intermediate frequency, a specific local oscillation signal MΔ is generated by means of a frequency divider/phase shifter. Therefore, a small size and economical system using a microprocessor, suitable for automatic referencing, can be provided, in which no multiplier need be used and in which phase referencing of receiving channels can be effected using digital IC's and, moreover, in which leakage of local signals can be prevented.

4. The use of a highly sophisticated oscillator for phase referencing and phase discrimination is not necessary because phase reference pulses can be generated using a voltage controlled oscillator provided in respect of the receiving channel corresponding to the master station. Moreover, problems arising from pull-in frequency difference which often occur in a method employing two oscillators 19 and 72 as shown in Figure 1(a) can be prevented.

5. A specified intermediate frequency signal is generated from the beat frequency (frequency difference) between the output signal $f_v$ of the voltage controlled oscillator provided in respect of the receiving channel corresponding to the master station and the output signal $f_R$ of the local oscillator, and any frequency drift of the local oscillator is included in a local oscillation signal employed for modulating a receiving signal into an intermediate frequency signal, and thereby effects of frequency drift of the local oscillator can be cancelled.

As will be clear from the above explanation, a receiver, for a hyperbolic navigation system, embodying the present invention can provide for a drastic reduction in size and cost as compared with previously proposed receivers, and also allows ship location measurements to be performed with high accuracy employing digital IC's.

**Claims**

1. A hyperbolic navigation receiver having first (2, 3, 4, 17, 18) and second (5, 6, 7, 14; 8, 9, 10, 16; 11, 12, 13, 15) receiving channels, being a master channel and a slave channel respectively, corresponding respectively to a master station and a slave station of a hyperbolic navigation system, each said receiving channel comprising receiving means for receiving and distinguishing a receiving signal (6f; 5f, 8f, 9f) pertinent to the channel concerned and the said receiving channels being operable respectively to provide first and second channel output signals in dependence upon such pertinent receiving signals,

first (36, 37, 38, 55) and second (44, 45, 39, 56; 47, 48, 57; 50, 51, 58) tracking loop filters operable respectively to provide first and second tracking output signals of frequencies equal respectively to those of the first and second channel output signals,

first (35) and second (43, 46, 49) phase discriminating means operable respectively to phase discriminate the first channel output signal and the first tracking output signal and to phase discriminate the second channel output signal and the second tracking output signal, and

further phase discrimination means (54, 34, 40) operable to phase discriminate signals derived from the first and second tracking loop filters,

the first and second tracking loop filters each comprising first generating means (37, 38, 45, 48, 51) operable to provide a generator output signal of a frequency a multiple of that of the receiving channel output signal with which the tracking output signal of the filter is phase-discriminated, and first frequency dividing means (36, 44, 47, 50) for dividing the frequency of the generator output signal to that of the receiving channel output signal with which the tracking output signal of the filter is phase-discriminated, the first generating means of the first tracking loop filter comprising a first voltage controlled oscillator (38) and the first generating means of the second tracking loop filter comprising a voltage controlled phase shifter (45, 48, 51) arranged to receive a signal derived from the first tracking loop filter,

the receiver further comprising second generating means (19 to 26) operable to generate a local signal,

and each receiving means comprising input means (2, 5, 8, 11) for a receiving signal pertinent to the channel concerned, and

first mixing means (3, 6, 9, 12) for mixing a signal from the input means with a mixing signal of a frequency dependent upon that of the receiving signal pertinent to the channel concerned, derived from the local signal, to provide an intermediate frequency signal as the receiving channel output signal of the channel concerned, characterised in that

each receiving means has second frequency dividing means (17, 14, 16, 15) for dividing the frequency of the local signal to provide the mixing signal for the first mixing means of the receiving means concerned.

2. A receiver as claimed in claim 1, wherein cutting means (S2) are provided which are operable to cut the loop of one (36, 37, 38, 55) of the first and second tracking loop filters, and wherein the receiver further comprises a voltage controlled phase shifter (30) arranged to receive the output signal of the first frequency dividing means (36) of the one tracking loop filter (or a signal frequency-divided from that output signal) and arranged to be controlled in dependence upon the output of that one (35) of the first and second phase discriminating means which is operable to phase discriminate the tracking output signal of the one tracking loop filter and a receiving output signal, third frequency dividing means (29, 33; 65) operable to frequency divide the said output signal of the first frequency dividing means of the one tracking loop filter and/or operable to divide the output signal of the voltage controlled phase shifter arranged to receive the output signal of the first frequency dividing means of the one tracking loop filter, to provide a signal of a basis intermediate frequency (1F), second mixing means (28) operable to mix the signal of the basic intermediate frequency with a local signal of a basic frequency (1Δ), and means (27, 51) for supplying the output of the second mixing means (28) as a reference receiving signal (1f) to the first mixing means (3, 6, 9, 12) of each receiving means.

3. A receiver as claimed in claim 2, wherein the cutting means (S2) are operable to cut the loop of the first tracking loop filter (36, 37, 38, 55).

4. A receiver as claimed in any preceding claim, wherein the second frequency dividing means (14, 16, 15) of the receiving means of the second channel are such that an initial condition of the frequency dividing means and the frequency division ratio of the frequency dividing means can be controlled for referencing of the phase of an output signal of the channel (Fig. 4).

5. A receiver as claimed in any preceding claim wherein the second generating means comprises a second voltage controlled oscillator (26) and oscillating means (19) operable to generate an output signal of a predetermined frequency, the second voltage controlled oscillator being arranged to be controlled in dependence upon the output signal of the oscillating means, and wherein the first generating means (37, 38) of the first tracking loop filter (36, 37, 38, 55) comprises means (37) for mixing the output signal of the first voltage controlled oscillator (38) thereof with the output signal of the oscillating means (19).

6. A receiver as claimed in any preceding claim, having a plurality of second receiving channels.

**Patentansprüche**

1. Hyperbolischer Navigationsempfänger mit ersten (2, 3, 4, 17, 18) und zweiten (5, 6, 7, 14; 8, 9, 10, 16; 11, 12, 13, 15) Empfangskanälen, die jeweils ein Mutterkanal und ein Tochterkanal sind, welche jeweils einer Mutterstation und einer Tochterstation eines hyperbolischen Navigationssystems entsprechen, wobei jeder genannte Kanal Empfangseinrichtungen zum Empfang und zur Unterscheidung eines Empfangssignals (6f; 5f, 8f, 9f) umfaßt, welches zu dem betreffenden Kanal gehört, und wobei die genannten Empfangskanäle jeweils betrieben werden können, um erste und zweite Kanalausgangssignale in Abhängigkeit von solchen zugehörigen Empfangssignalen zu liefern,

ersten (36, 37, 38, 55) und zweiten (44, 45, 39, 56; 47, 48, 57; 50, 51, 58) Gleichlaufschleifenfiltern, die jeweils betrieben werden können, um erste und zweite Gleichlaufausgangssignale mit Frequenzen zu liefern, die jeweils gleich denjenigen der ersten und zweiten Kanalausganssignale sind;

ersten (35) und zweiten (43, 36, 49) Phasendiskriminierungseinrichtungen, die betrieben werden können, um das erste Kanalausgangssignal von dem ersten Gleichlaufausgangssignal zu unterschdeden bzw. das zweite Kanalausgangssignal von dem zweiten Gleichlaufausgangssignal zu unterscheiden, und

weiteren Diskriminatoreinrichtungen (54, 34, 40), die zur Phasendiskriminierung von Signalen betrieben werden können, welche von den ersten und zweiten Gleichlaufschleifenfiltern abgeleitet sind,

wobei die ersten und zweiten Gleichlaufschleifenfilter jeweils erste Generatoreinrichtungen (37, 38, 45, 48, 51) umfassen, die zur Erzeugung eines Generatorausgangssignals mit einer Frequenz betrieben werden können, welche ein Vielfaches derjenigen des Empfangskanalsausgangssignals ist, mit welchem das Gleichlaufausgangssignal des Filters phasendiskriminiert wird, und erste Frequenzteilereinrichtungen (36, 44, 47, 50) zur Teilung der Frequenz des Generatorausgangssignals zu derjenigen des Empfangskanalsausgangssignals, mit welchem das Gleichlaufausgangssignal des Filters phasendiskriminiert wird, wobei die erste Generatoreinrichtung des ersten Gleichlaufschleifenfilters einen ersten spannungsgesteuerten Oszillator (38) umfaßt und die erste Generatoreinrichtung des zweiten Gleichlaufschleifenfilters einen spannungstesteuerten Phasenschieber (45, 48, 51) umfaßt, welcher zum Empfang eines Signals angeordnet ist, das von dem ersten Gleichlaufschleifenfilter abgeleitet ist; und

ferner mit zweiten Generatoreinrichtungen (19 bis 26) die zur Erzeugung eines lokalen Signals betrieben werden können, und bei welchem .

jede Empfangseinrichtung eine Eingangseinrichtung (2, 5, 8, 11) für ein Empfangssignal umfaßt, das zu dem betreffenden Kanal gehört, und erste Mischeinrichtungen (3, 6, 9, 12) zum Mischen eines Signals von der Eingangseinrichtung mit einem Mischsignal von einer Frequenz, die von derjenigen des Empfangssignals, welches zu dem betreffenden Kanal gehört, abhängt, das von dem lokalen Signal abgeleitet ist, um ein Zwischenfrequenzsignal als das Empfangskanalausgangssignal des betreffenden Kanals zu liefern, dadurch gekennzeichnet, daß

jede Empfangseinrichtung eine zweite Teilungseinrichtung (17, 14, 16, 15) zur Teilung der Frequenz des lokalen Signals umfaßt, um das Mischsignal für die erste Mischeinrichtung der betreffenden Empfangseinrichtung zu liefern.

2. Empfänger nach Anspruch 1, bei welchem Trenneinrichtungen (S2) vorgesehen sind, welche betrieben werden können, um die Schleife des ersten oder zweiten Gleichlaufschleifenfilters zu trennen, und bei welchem der Empfänger ferner einen spannungsgesteuerten Phasenschieber (30) umfaßt, der zum Empfang des Ausgangssignals der ersten Frequenzteilereinrichtung (36) des einen Gleichlaufschliefenfilters (oder eines frequenzgeteilten Signals des Ausgangssignals) angeordnet ist, und welcher angeordnet ist, um in Abhängigkeit von dem Ausgang von der ersten (35) oder der zweiten Phasendiskriminatoreinrichtung gesteuert zu werden, welche zur Phasendiskriminierung zwischen dem Gleichlaufausgangssignal von einem Gleichlaufschleifenfilter und einem Empfangsausgangssignal betriebbar ist.

dritte Frequenzteilereinrichtungen (29, 33; 65) welche betrieben werden können, um die Frequenz des genannten Ausgangssignal der ersten Frequenzteilereinrichtungen des einen Gleichlaufschleifenfilters zu teilen, und/oder betreibbar sind, um das Ausgangssignal des spannungsgesteuerten Phasenschiebers zu teilen, der zum Empfang des Ausgangssignals der ersten Frequenzteilereinrichtung von dem einen Gleichlaufschleifenfilter angeordnet ist, um ein Signal mit einer Basiszwischenfrequenz (1F) zu liefern,

zweite Mischeinrichtungen (28), die betreibbar sind, um das Signal der Basiszwischenfrequenz mit einem lokalen Signal von einer Basisfrequenz (1Δ) zu mischen, und

Einrichtungen (27, 51), um das Ausgangssignal der zweiten Mischeinrichtung (28) als ein Referenzempfangssignal (1f) den ersten Mischeinrichtung (3, 6, 9, 12) jeder Empfangseinrichtung zuzuführen.

3. Empfänger nach Anspruch 2, bei welchem die Trenneinrichtung (S2) betrieben werden kann, um die Schleife des ersten Gleichlaufschleifenfilters (36, 37, 38, 55) aufzutrennen.

4. Empfänger nach einem der vorhergehenden Ansprüche, bei welchem die zweiten Frequenzteilereinrichtungen (14, 16, 15) der Empfangseinrichtungen des zweiten Kanals so sind, daß ein anfänglicher Zustand der Frequenzteilereinrichtungen und das Frequenzteileungsverhältnis der Frequenzteilereinrichtungen gesteuert werden können, um ein Referenz der Phase eines Ausgangssignals des Kanals (Figur 4) zu bilden.

5. Empfänger nach einem der vorhergehenden Ansprüche, bei welchem die zweite Generatoreinrichtung einen zweiten spannungsgesteuerten Oszillator (26) und Oszillatoreinrichtungen (19) umfaßt, die betrieben werden können, um ein Ausgangssignal vorbestimmter Frequenz zu liefern,

der zweite spannungsgesteuerte Oszillator so angeordnet ist, daß er in Abhängigkeit von dem Ausgangssignal der oscillierenden Einrichtung gesteuert werden kann, und bei welcher die ersten Generatoreinrichtungen (37, 38) des ersten Gleichlaufschleifenfilters (36, 37, 38, 55) Einrichtungen (37) zum Mischen des Ausgangssignals des ersten Spannungsgesteuerten Oszillators (38) desselben mit dem Ausgangssignal der oszillierenden Einrichtungen (19) umfassen.

6. Empfänger nach einem der vorhergehenden Ansprüche, mit einer Vielzahl von zweiten Empfangskanälen.

## Revendications

1. Récepteur de navigation hyperbolique comportant un premier (2, 3, 4, 17, 18) et un second (5, 6, 7, 14; 8, 9, 10, 16; 11, 12, 13, 15) canaux de réception, à savoir un canal pilote et un canal asservi respectivement, correspondant respectivement à une station pilote et une station asservie d'un système de navigation hyperbolique, chacun desdits canaux de réception comportant un dispositif de réception pour recevoir et distinguer un signal de réception (6f, 5f, 8f, 9f) correspondant au signal concerné et lesdits canaux de réception produisant respectivement des signaux de sortie de premier et de second canal en fonction de ces signaux de réception correspondants, un premier (36, 37, 38, 55) et un second (44, 45, 39, 56; 47, 48, 57; 50, 51, 58) filtre à boucle de poursuite produisant respectivement un premier et un second signal de sortie de poursuite de fréquences égales respectivement à celles des signaux de sortie du premier et du second canal, un premier (35) et un second (43, 46, 49) discriminateur de phase ayant pour fonction respectivement de discriminer en phase le signal de sortie du premier canal et le premier signal de sortie de poursuite et de discriminer en phase le signal de sortie du second canal et le second signal de sortie de poursuite et un autre discriminateur de phase (54, 34, 40) discriminant en phase des signaux produits à partir du premier et du second filtre à boucle de poursuite, le premier et le second filtre à boucle de poursuite comportant chacun un premier générateur (37, 38, 45, 48, 51) produisant un signal de sortie de générateur d'un fréquence multiple de celle du signal de sortie du canal de réception avec lequel le signal de sortie de poursuite du filtre est discriminé en phase et un premier diviseur de fréquence (36, 44, 47, 50) pour diviser la fréquence du signal de sortie de générateur jusqu'à celle du signal de sortie du canal de réception avec lequel le signal de sortie de poursuite du filtre est discriminé en phase, le premier générateur du premier filtre à boucle de poursuite comportant un premier oscillateur commandé par tension (38) et le premier générateur du second filtre à boucle de poursuite comportant un déphaser commandé par tension (45, 48, 51) agencé pour recevoir un signal produit à partir du premier filtre à boucle de poursuite, le récepteur comportant en outre un second générateur (19 à 26) produisant un signal local et chaque dispositif de réception comprenant un dispositif d'entrée (2, 5, 8, 11) pour un signal de réception correspondant au signal concerné et un premier mélangeur (3, 6, 9, 12) pour mélanger un signal provenant du dispositif d'entrée avec un signal de mélange d'une fréquence qui dépend de celle du signal de réception correspondant au canal concerné, produit à partir du signal local pour obtenir un signal de fréquence intermédiaire comme signal de sortie du canal de réception du canal concerné, caractérisé en ce que chaque dispositif de réception comporte un second diviseur de fréquence (17, 14, 16, 15) pour diviser la fréquence du signal local et produire le signal de mélange pour le premier mélangeur du dispositif de réception concerné.

2. Récepteur selon la revendication 1, dans lequel des dispositifs de coupure (S2) sont prévus pour couper la boucle de l'un (36, 37, 38, 55) du premier et du second filtre à boucle de poursuite et dans lequel le récepteur comporte également un déphaser commandé par tension (30) agencé pour recevoir le signal de sortie du premier diviseur de fréquence (36) d'un filtre à boucle de poursuite (ou un signal divisé en fréquence à partir de ce signal de sortie) et agencé pour être commandé en fonction de la sortie de celui (35) du premier et du second discriminateur de phase qui discrimine en phase le signal de sortie de poursuite du filtre à boucle de poursuite et un signal de sortie de réception, un troisième diviseur de fréquence (29, 33, 65) divisant la fréquence dudit signal de sortie du premier diviseur de fréquence dudit filtre à boucle de poursuite et/ou divisant le signal de sortie du déphaseur commandée par tension, agencé pour recevoir le signal de sortie du premier diviseur de fréquence dudit filtre à boucle de poursuite pour produire un signal d'une fréquence intermédiaire de base (1F), un second mélangeur (28) mélangeant le signal de fréquence intermédiaire de base avec un signal local d'une fréquence de base (1Δ) et un dispositif (27, 51) pour fournir la sortie du second mélangeur (28) comme un signal de réception de référence (1f) au premier mélangeur (3, 6, 9, 12) de chaque dispositif de réception.

3. Récepteur selon la revendication 2, dans lequel le dispositif de coupure (S2) a pour fonction de couper la boucle du premier filtre à boucle de poursuite (36, 37, 38, 55).

4. Récepteur selon l'une quelconque des revendications précédentes, dans lequel le second diviseur de fréquence (14, 16, 15) du dispositif de réception du second canal est tel qu'une condition initiale du diviseur de fréquence et le rapport de devision de fréquence du diviseur de fréquence peuvent être commandés pour la référence de phase d'un signal de sortie du canal (Fig. 4).

5. Récepteur selon l'une quelconque des revendications précédentes dans lequel le second générateur comporte un second oscillateur commandé par tension (26) et un dispositif oscillatoire (19) produisant un signal de sortie d'une fréquence prédéterminée, le second oscillateur commandé par tension étant agencé pour être commandé en fonction du signal du dispositif oscillatoire, et dans lequel le premier générateur (37, 38) du premier filtre à boucle de poursuite (36, 37, 38, 55) comporte un dispositif (37) pour mélanger le signal de sortie du premier oscillateur commandé par tension (38) avec le signal de sortie du dispositif oscillatoire (19).

6. Récepteur selon l'une quelconque des revendications précédentes, comprenant plusieurs seconds canaux de récéption.

Fig 1(a)

0 057 073

Fig. 1 (b)

FIG. 2

# Fig. 3

*Fig. 4*

Fig. 5

Fig. 6